Europäisches Patentamt

European Patent Office

Office européen des brevets

(19)

(11) Veröffentlichungsnummer: **0 078 405**
**A2**

(12) # EUROPÄISCHE PATENTANMELDUNG

(21) Anmeldenummer: **82109113.9**

(22) Anmeldetag: **02.10.82**

(51) Int. Cl.³: **H 05 K 5/00**

(30) Priorität: **04.11.81 DE 8132259 U**

(43) Veröffentlichungstag der Anmeldung: **11.05.83**
**Patentblatt 83/19**

(84) Benannte Vertragsstaaten: **AT BE CH DE FR GB IT LI NL SE**

(71) Anmelder: **Bündoplast GmbH & Co. KG,
Uhlendieckstrasse 134-140,
D-4980 Bünde 1 Industriegebiet West (DE)**

(72) Erfinder: **Frankowski, Günter, Meyerstrasse 5,
D-4980 Bünde 17 (DE)**

(74) Vertreter: **Thielking, Bodo, Dipl.-Ing. et al, Patentanwälte
Dipl.-Ing. Bodo Thielking Dipl.-Ing. Otto Elbertzhagen
Gadderbaumer Strasse 20, D-4800 Bielefeld 1 (DE)**

(54) **Einbaugehäuse.**

(57) Übliche Einbaugehäuse für vorzugsweise elektrische Bauelemente bestehen aus einem ringartig umlaufend ausgebildeten Mittelteil mit einem anschraubbaren Deckel und einem Bodenteil. Die Größe solcher Einbaugehäuse ist durch die Größe des Mittelteils bestimmt. Eine Änderung der Gehäusemaße ist nur durch die Wahl unterschiedlich großer Mittelteile möglich, die jeweils mit unterschiedlichen Werkzeugen hergestellt werden müssen. Das neue Einbaugehäuse besteht aus mindestens zwei Ringelementen, die in Mittelachsrichtung von Zugankern, durchsetzt sind, welche beidseitig mit Boden und Deckel verschraubt sind. Eine solche Konstruktion erlaubt den Aufbau unterschiedlicher Einbaugehäuse aus wenigen und gleichartigen Bauteilen im Baukastensystem.

## Einbaugehäuse

Die Erfindung betrifft ein Einbaugehäuse für elektrische, elektronische, pneumatische oder hydraulische Bauelemente, mit einem umlaufend ringförmig ausgebildeten Mittelteil sowie mit anschraubbarem Deckel und Boden.

Ein bekanntes Einbaugehäuse dieser Art besitzt ein einziges Mittelteil mit Gewindebohrungen an den offenen Stirnseiten, die zur Aufnahme der Befestigungsschrauben für Deckel und Boden dienen.

Nachteilig sind derartige bekannte Einbaugehäuse vor allen Dingen deshalb, weil für unterschiedliche Längen der Einbaugehäuse, die von den Verbrauchern gefordert werden, unterschiedlich lange Mittelteile verwendet werden müssen. Bei gespritzten Gehäusen dieser Art entstehen also hohe Werkzeugkosten für die unterschiedlichen Ausführungsformen bzw. für die unterschiedlichen Gehäuselängen.

Der Erfindung liegt die Aufgabe zugrunde, ein Gehäuse der eingangs erwähnten Art so auszubilden, daß das Gehäuse unterschiedliche Längen aufweisen kann, ohne daß für unterschiedliche Gehäuselängen jeweils unterschiedliche Werkzeuge erforderlich sind.

Die Lösung dieser Aufgabe erfolgt erfindungsgemäß dadurch, daß das Kunststoffspritzgußgehäuse einen Mittelteil aus mindestens zwei Ringelementen aufweist, die in Mittelachsrichtung von Zugankern durchsetzt sind, wobei die Zuganker beidseitig mit Boden und Deckel verschraubt sind.

Bei einer bevorzugten Ausführungsform weisen die Zuganker stirnseitig Gewindebohrungen für Befestigungsschrauben von Deckel- oder Bodenteil auf.

Ferner wird erfingungsgemäß vorgeschlagen, daß die Zuganker eine unrunde Kontur aufweisen und unverdrehbar in den zugehörigen Längskanälen angeordnet sind.

Eine bevorzugte Ausführungsform der unrunden Zuganker ist eckig ausgebildet.

Gemäß einem weiteren Merkmal der Erfindung ist zwischen den beiden Ringelementen ein Zwischenring von kürzerer Länge angeordnet.

Dabei ist es zweckmäßig, daß Entlüftungsöffnungen im Zwischenring vorgesehen sind.

Gemäß einem weiteren Merkmal der Erfindung weist der Zwischenring eine quer zur Achsrichtung sich erstreckende Trennwand auf.

0078405

Weiterhin wird vorgeschlagen, daß ein Ringelement einen umlaufenden Außenflansch aufweist. Diese Ausführungsform erlaubt einen einfachen Einschub von Schalttafeln.

Schließlich wird erfindungsgemäß vorgeschlagen, daß auf der Vorderseite des Gehäuses verstellbare Klemmschrauben angeordnet sind. Diese verstellbaren Klemmschrauben erlauben einen einfachen Einsatz und ein einfaches Entnehmen von Schalttafeleinbauten.

Das neuerungsgemäße Gehäuse ist universell anwendbar. Es ist durch einfaches Zusammenfügen von gleichen oder gleichartigen Teilen beliebig verlängerbar und auf alle Bedürfnisse der Praxis abstimmbar.

Nachstehend werden bevorzugte Ausführungsformen der Erfindung anhand der Zeichnung im einzelnen beschrieben. Es zeigen:

Figur 1 - eine perspektivische Explosionsdarstellung einer ersten Ausführungsform,

Figur 2 - eine perspektivische Darstellung eines einzelnen Ringelements für Schalttafelaufbau,

Figur 3 - eine perspektivische Darstellung einer Klemmschraubenausführung für das Gehäuse,

Figur 4 - eine perspektivische Darstellung eines Ringelements mit Entlüftungsöffnungen und mittlerer Trennwand.

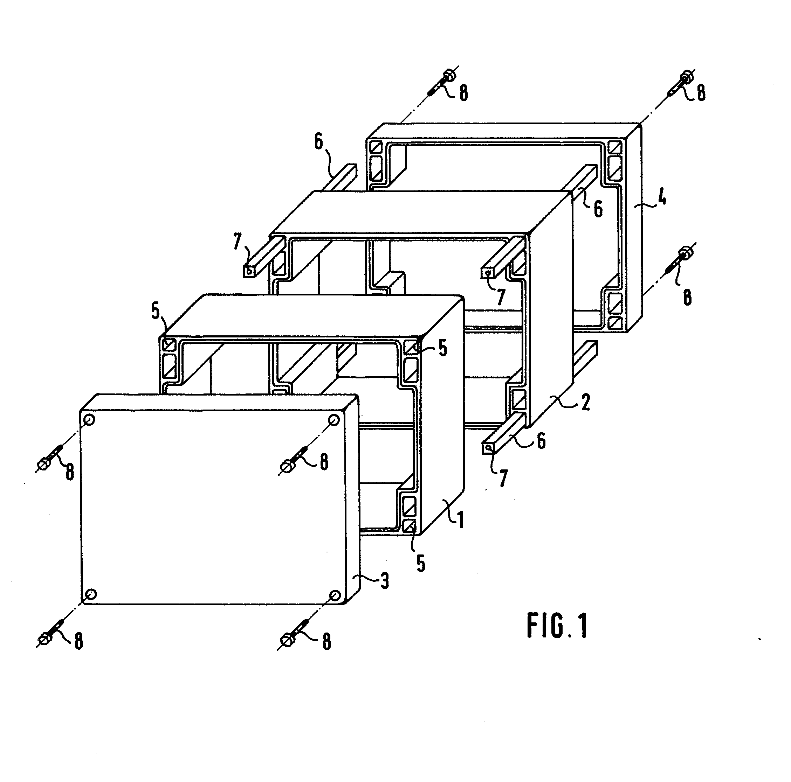

Bei der ersten Ausführungsform gemäß Figur 1 besteht das Gehäuse aus zwei gleichen Ringelementen
1 und 2, die auf der Vorderseite durch den Deckel
3 und auf der Rückseite durch den Boden 4 verschließbar sind. Die Ringelemente 1 und 2 besitzen
quadratische oder rechteckige Form und weisen in
Mittelachsrichtung verlaufende Längskanäle 5 auf,
welche von passenden quadratischen Zugankern 6
durchsetzt sind. Die Zuganker 6 weisen stirnseitig Gewindebohrungen 7 auf, welche zur Aufnahme der vorgesehenen Befestigungsschrauben 8
für Deckel- und Bodenteile 3 und 4 dienen.

Bei einer nicht dargestellten Ausführungsform ist
ein Zwischenring 9 zwischen den beiden Ringteilen
1 und 2 angeordnet, der ebenfalls Längskanäle 5
aufweist, die von den Zugankern 6 durchsetzt sind.
Der Zwischenring 9 besitzt eine Trennwand 10 sowie als Entlüftungsöffnungen dienende Durchbrüche
11 in der Ringwandung. Die Durchbrüche 11 sind
lediglich auf einer Seite der Trennwand 10 vorgesehen.

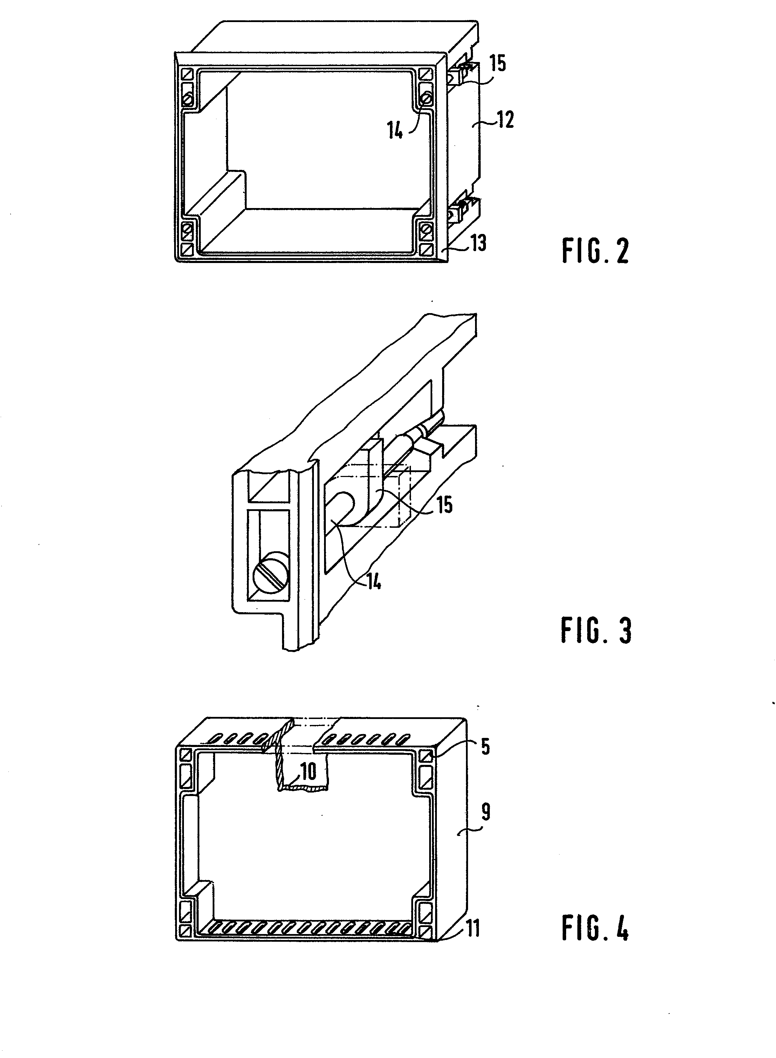

In den Figuren 2 und 3 sind Einzelheiten einer
Gehäuseausbildung dargestellt, welche für den
Schalttafeleinbau dient. Das Ringteil 12 ist
mit einem umlaufenden, über die Kontur des
Ringteils vorstehenden Außenflansch versehen.
Im Ringteil 12 sind in Längsrichtung verlaufende Klemmschrauben 14 drehbar und axial
unverschieblich gelagert. Auf den Klemmschrauben
14 sitzen verschwenkbare Klemmuttern 15, die
selbsthemmend auf dem Gewinde der Klemmschrauben

0078405

sitzen. Bei einer Verdrehung der Klemmutter 15 gemäß Figur 3 nach rechts verschwenkt die Klemmutter aus der durchgezogen dargestellten Lage in die strichpunktierte Lage, in der diese Klemmutter hinter ein Gegenlager greift. Bei einem weiteren Verdrehen der Klemmutter legt sich diese fest an das Gegenlager an. Für ein Lösen der Klemmutter, wie es bei einem Ausbau des Gehäuses erforderlich ist, wird die Klemmschraube 14 im Gegenuhrzeigersinn gedreht und schwenkt dann hinter die Außenkontur des Ringteils 12 in die durchgezogen dargestellte Lage ein.

0078405

Patentansprüche:

1. Einbaugehäuse für elektrische, elektronische, pneumatische oder hydraulische Bauelemente, mit einem umlaufend ringförmig ausgebildeten Mittelteil sowie mit anschraubbarem Deckel und Boden,
dadurch gekennzeichnet,
daß das Kunststoffspritzgußgehäuse einen Mittelteil aus mindestens zwei Ringelementen (1; 2) aufweist, die in Mittelachsrichtung von Zugankern (6) durchsetzt sind, wobei die Zuganker (6) beidseitig mit Boden (4) und Deckel (3) verschraubt sind.

2. Einbaugehäuse nach Anspruch 1,
dadurch gekennzeichnet,
daß die Zuganker (6) stirnseitig Gewindebohrungen (7) für Befestigungsschrauben (8) von Deckel (3) oder Boden (4) aufweisen.

3. Einbaugehäuse nach Ansprüchen 1 und 2,
dadurch gekennzeichnet,
daß die Zuganker (6) eine unrunde Kontur aufweisen und unverdrehbar in den zugehörigen Längskanälen (5) angeordnet sind.

4. Einbaugehäuse nach Anspruch 3,
dadurch gekennzeichnet,
daß die unrunden Zuganker (6) eckig ausgebildet sind.

5. Einbaugehäuse nach einem oder mehreren der Ansprüche 1 bis 4,
dadurch gekennzeichnet,

daß zwischen den Ringelementen (1 und 2)
ein Zwischenring (9) von kürzerer Länge angeordnet ist.

6. Einbaugehäuse nach einem oder mehreren der
Ansprüche 1 bis 5,
dadurch gekennzeichnet,
daß Entlüftungsöffnungen (11) im Zwischenring
(9) vorgesehen sind.

7. Einbaugehäuse nach einem oder mehreren der
Ansprüche 1 bis 6,
dadurch gekennzeichnet,
daß der Zwischenring (9) eine sich quer zur
Achsrichtung erstreckende Trennwand (10)
aufweist.

8. Einbaugehäuse nach einem oder mehreren der
Ansprüche 1 bis 7,
dadurch gekennzeichnet,
daß ein Ringelement (12) einen umlaufenden
Außenflansch (13) aufweist.

9. Einbaugehäuse nach einem oder mehreren der
Ansprüche 1 bis 8,
dadurch gekennzeichnet,
daß auf der Vorderseite des Gehäuses verstellbare Klemmschrauben (14) mit Klemm-
muttern (15) angeordnet sind.

FIG.1

FIG. 2

FIG. 3

FIG. 4